# EUROPEAN PATENT SPECIFICATION

(11) **EP 3 164 537 B1**
(45) Date of publication and mention of the grant of the patent: **31.01.2018**
(21) Application number: 14736359.2
(22) Date of filing: 02.07.2014
(51) Int. Cl.: D06F 39/00, H03K 17/96

(54) **A CONTROL PANEL ASSEMBLY FOR AN ELECTRICAL HOUSEHOLD APPLIANCE**
STEUERTAFELANORDNUNG FÜR EIN ELEKTRISCHES HAUSHALTSGERÄT
ENSEMBLE PANNEAU DE COMMANDE POUR UN APPAREIL ÉLECTROMÉNAGER

(43) Date of publication of application: 10.05.2017
(73) Proprietor: Arçelik Anonim Sirketi, 34950 Istanbul (TR)
(72) Inventor: CETINKAYA, Bugra, 34950 Istanbul (TR); TEKDEMIR, Baris, 34950 Istanbul (TR); KARACA, Sema, 34950 Istanbul (TR); USTUNER VARDAR, Sevim, 34950 Istanbul (TR); METIN, Ergin, 34950 Istanbul (TR)
(86) International application number: PCT/EP2014/064009
(87) International publication number: WO 2016/000769

(56) References cited:
- EP-A2- 1 924 000
- EP-A2- 2 442 035
- WO-A1-2014/010182
- US-A1- 2012 249 467

## Description

The present invention relates to a control panel assembly for an electrical household appliance.

Modern household appliances have different structural forms. A washing machine usually accommodates the control panel units on the upper front face of the appliance. For ease of access, the control panels are designed in a way to face the user. For aesthetic or design purposes, this surface might have a convex form. Unfortunately this curved form of the control panel inhibits the usage of the circuit boards.

Flexible circuit boards are easier to accommodate in electronic devices and they provide the manufacturer with alternative design options not dependent on the size and structure of the circuit board.

These circuit boards may be used as input devices for touch enabled control units. The circuit board needs to be in direct contact with the control panel, where the user will control the device by touching. If the connection between the control panel and the flexible circuit board is weak or broken, the system may not operate in the predetermined manner. It is to be noted that, it is essential for the control unit that the flexible circuit board is in direct contact with the control panel.

Although the circuit board is flexible, a certain amount force needs to be exerted on the circuit board to acquire a preferred shape. Also when this force is removed, the circuit board tends to flatten out. Due to its structural nature, when glued on a concave/convex surface, the flexible board unit tends to lift up from the attached surface and the connection between the circuit board and the control panel is broken.

A prior art publication in the technical field of the present invention may be referred to as WO2013064572 among others, the document disclosing a household appliance comprising a control panel having a designated area which provides the user to select the desired program parameters by touching, a circuit board having a sensor situated behind the control panel and a touch button having at least one spring one end of which is fixed to the circuit board and which transmits to the sensor the capacitive difference that is formed when the designated area is touched and a plate which is fixed to the free end of the spring and the diameter of which is larger than the diameter of the spring.

Prior art document WO 2014/010182 A1 describes a washing machine with a display device comprising a transparent plate, a liquid crystal panel with an attachment base, and a main control board stacked on one another in said order. US 2012/0249467 A1 discloses a household appliance having a touch user interface that includes a touch panel with a touch area and a printed circuit board with a capacitive touch sensor trace and wherein the printed circuit board is mounted to the touch panel such that the capacitive touch sensor trace is aligned with the touch area.

The aim of this invention is to provide a durable household appliance for the user, which would operate without fail for a long period of time. To achieve this, a control unit with a support plate that ensures thorough contact between the flexible circuit board and the control panel is provided. The present invention relates to a control panel assembly for an electrical household appliance as defined in claim 1 and to a method for mounting the support plate of a control panel according to claim 1 as defined in claim 10. Further features of the control panel assembly are defined in dependent claims 2-9. Accompanying drawings are given solely for the purpose of exemplifying a control panel unit, whose advantages over prior art were outlined above and will be explained in brief hereinafter.

The drawings are not meant to delimit the scope of protection as identified in the claims nor should they be referred to alone in an effort to interpret the scope identified in said claims without recourse to the technical disclosure in the description of the present invention.

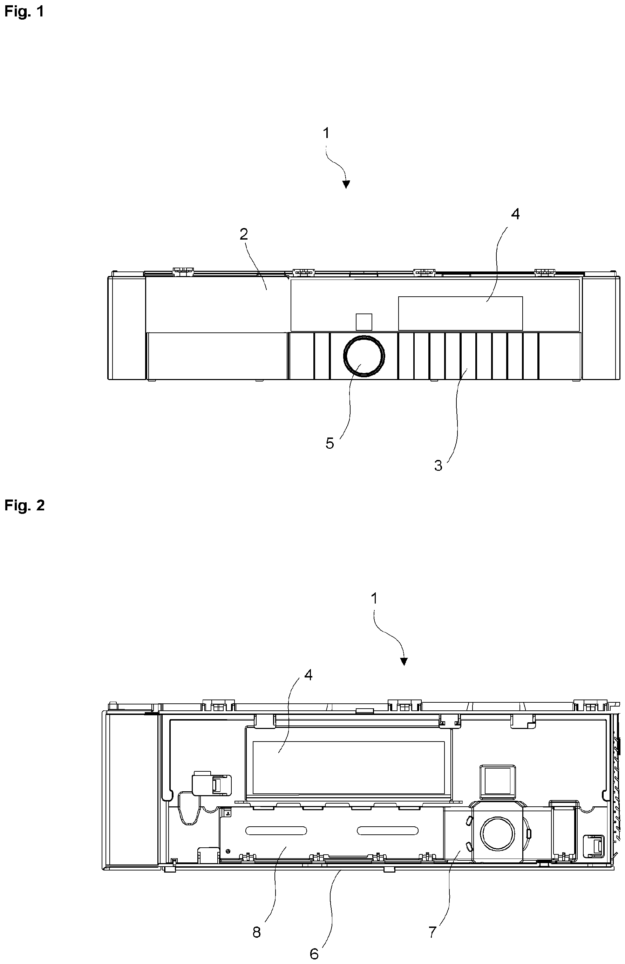

Figure 1 demonstrates a general schematic front view of the control panel assembly according to the present invention.
Figure 2 demonstrates a general schematic back view from the interior side of the control panel assembly according to the present invention.
Figure 3 demonstrates a general schematic view of the flexible circuit board according to the present invention.
Figure 4 demonstrates a general schematic view of the support plate with connection units on opposite sides according to the present invention.

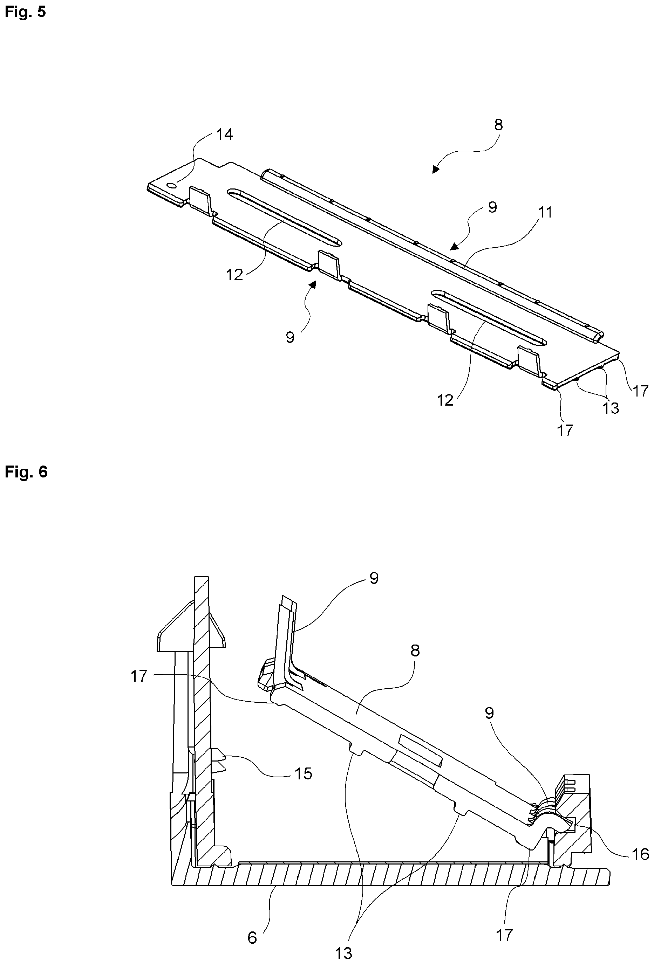

Figure 5 demonstrates a general schematic view of the support plate with a continuous connection unit on one side according to the present invention.
Figure 6 demonstrates a general schematic view of the first step of mounting of the support plate in the control panel frame according to the present invention.

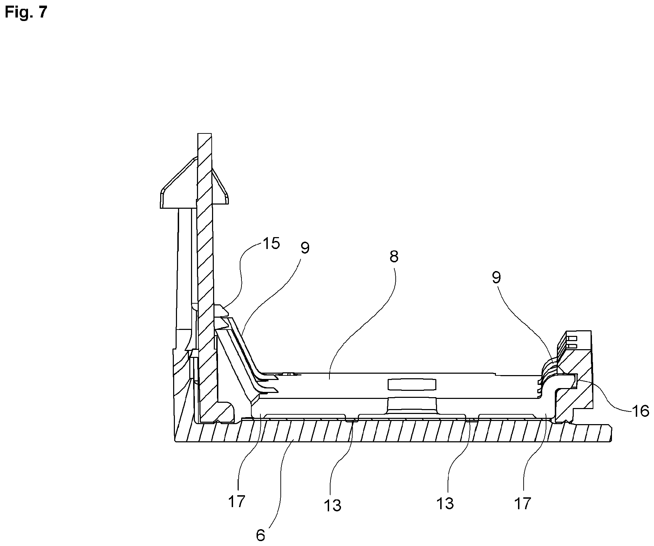

Figure 7 demonstrates a general schematic view of the mounted support plate in the control panel frame according to the present invention.

The following numerals are assigned to different parts demonstrated in the drawings:
1. Control panel assembly
2. Outer control panel
3. Touch input device
4. Output/display device
5. Touch buttons
6. Control panel frame
7. Circuit board
8. Support plate
9. Connection unit
10. Discontinuous connection unit
11. Continuous connection unit
12. Flexure Slot
13. Longitudinal protrusion
14. Positioning hole
15. Engagement extensions
16. Control panel slot
17. Edge protrusions

The present invention provides a touch enabled control panel assembly (1) for an electrical household appliance such as for instance a laundry treatment appliance, comprising an outer control panel (2), an electronic flexible input/output device (a flexible printed circuit board (7)) to be attached in the inner face of the control panel frame (6) and a support plate (8) mounted behind the electronic flexible input/output device to secure the flexible input/output device.

The control panel assembly (1) of the present invention comprises an outer control panel (2). The outer control panel (2) comprises a touch input device (3) and an output/display device (4). The user controls the appliance by touching via the touch input device (3). The touch input device (3) may comprise touch buttons (5).

The information about the processing of the appliance is presented to the user on the output/display device (4). The input and the output devices may be arranged in a uniform assembly. The outer control panel (2) may additionally comprise a touch button (5) for additional data input.

The outer control panel (2) is connected or mounted on the control panel frame (6). The control panel frame (6) accordingly encloses the outer control panel (2). This frame also provides housing for the other units of the control panel assembly (1) such as the circuit board (7) and the support plate (8). The control panel frame (6) acts as an attachment and mounting base for these units.

In the interior face of the outer control panel (2), the flexible circuit board (7) is attached. The circuit board (7) may be glued to the inner surface of the outer panel. The circuit board (7) receives the information from the user via its contact with the touch input device (3) of the outer control panel (2). It is therefore essential that the circuit board (7) remains in direct contact with the touch input device (3). When the flexible circuit board (7) is not in contact with the touch input device (3), the information from the input device cannot be processed and the operation of the appliance fails.

To provide constant and thorough connection between the flexible circuit board (7) and the outer panel touch input device (3), a support plate (8) is mounted on the control panel frame (6). The support plate (8) provides support and tension for the flexible circuit board (7). The support plate (8) has a rigid structure and is mounted to cover the flexible circuit board (7). The support plate (8) provides tension for the flexible circuit board (7) so that it takes the convex shape of the control panel. As a result, the flexible circuit board (7) between the support plate (8) and the control panel is in direct contact with the control panel and enough tension is provided for the flexible circuit board (7) to receive information from the touch input device (3). Therefore, the structural disadvantage caused by the convex shape of the outer control panel (2) and affecting the positional accuracy of the circuit board (7) is overcome.

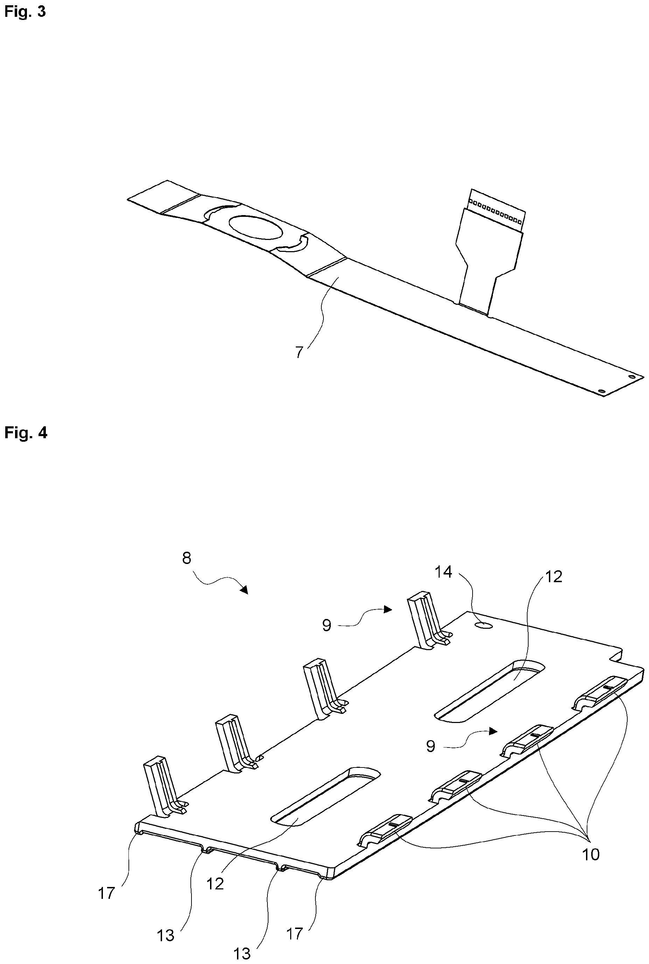

The support plate (8) of the invention comprises two sets of connection units (9) opposite to each other at two opposing sides of the support plate (8). Preferably, the support plate (8) comprises discontinuous connection units (10) on at least one side of the support plate (8). The connection between the control panel frame (6) and the support plate (8) is a reversible mechanical connection. The discontinuous connection units (10) are separated by grooves disposed in between as presented in Fig. 4. Engagement extensions (15) of the control panel frame (6) cooperate with the connection units (9) at the opposite side of said discontinuous connection units (10). Alternatively, continuous connection units (11) may be provided on the side of said discontinuous connection units (10). Said discontinuous or continuous connection units (11, 10) interengage with a control panel slot (16) such that the support plate (8) is fixedly secured at both opposite sides thereof so as to involve a tight-fit between the control panel frame (6) and the support plate (8).

The support plate (8) of the present invention is mounted in the control panel frame (6) by a two-step method. At first one of the sides of the support plate (8) is attached to the control panel frame (6). If there are any continuous connection units (11), this side is preferably attached first because a continuous edge simultaneously provides centering and fixating effect. Then by applying a force on the plate, the plate is bent and the second side opposite to the attached side is mounted. When mounted, the support plate (8) may also possess a convex shape matching the outer panel.

The support plate (8) may also comprise flexure slots (12) to release tension created on the plate by bending. These flexure slots (12) are preferably located on the same axis to provide uniform tension release and to prevent fracture formation that might result due to constant tension exerted on the support plate (8) by bending during mounting.

The flexure slots (12) may be located on a single axis or on multiple parallel axes. Preferably, the flexure slots (12) are located on an axis or axes parallel to a line along which the connection units (9) are successively disposed (as exemplified in Fig. 4). More preferably, two opposing side connection units (9) and the flexure slot (12) axes are all parallel to each other.

The length of a flexure slot (12) extending on the axis may be longer than its width. This provides appropriate tension release and prevents fracture formation on the support plate (8).

The support plate (8) may also comprise longitudinal protrusions (13) to support and exert extra tension on the flexible circuit board (7). Likewise, edge protrusions (17) also serve to the purpose of applying of a certain amount of force to the flexible circuit board (7) on a continual basis. Therefore a reciprocally maintained contact relationship is created to retain the flexible circuit board (7) in its predetermined position. Further, a positioning hole (14) is provided to help center the support plate (8) while being mounted.

## Claims

1. A control panel assembly (1) for a household appliance comprising:
- an outer control panel (2) with a convex form comprising a touch input device (3),
- an output/display device (4),
- a control panel frame (6) enclosing the outer control panel (2) and,
- a flexible electronic circuit board (7) attached on the interior of the control panel frame (6),
- a support plate (8) mounted behind the flexible electronic circuit board (7) to secure the same on the interior of the control panel frame (6),
wherein
- the support plate (8) has a rigid structure, covers the flexible circuit board (7), and provides tension for the flexible circuit board (7) so that it takes the convex shape of the control panel (2),
- the support plate (8) comprises connection units (9) such that at least two separate connection units (9) have separate parts of mechanical connection with the control panel frame (6) at two opposite sides of said support plate (8),
- the connection units (9) comprise:
(a) at least two discontinuous connection units (10) having separate parts of mechanical connection with the control panel frame (6) at one side of the support plate (8), or
(b) a continuous connection unit (11) effecting mechanical connection with the control panel frame (6) at one side of the support plate (8),
- the discontinuous or continuous connection units (10, 11) interengage with a control panel slot (16) of the control panel frame (6).

2. A control panel assembly (1) as in Claim 1, **characterized in that** engagement extensions (15) of the control panel frame (6) mechanically cooperate with multiple connection units (9) at the opposite side of said discontinuous or continuous connection units (10, 11).

3. A control panel assembly (1) as in any preceding Claims, **characterized in that** the support plate (8) comprises flexure slots (12).

4. A control panel assembly (1) as in Claim 3, **characterized in that** multiple flexure slots (12) are located on the same axis.

5. A control panel assembly (1) as in Claim 3, **characterized in that** multiple flexure slots (12) are located on parallel axes.

6. A control panel assembly (1) as in claim 4, **characterized in that** the flexure slots (12) are located on the same axis parallel to a line along which connection units (9) are disposed.

7. A control panel assembly (1) as in claim 3, **characterized in that** the length of a flexure slot (12) extending along a longitudinal axis of the support plate (8) is longer than its width.

8. A control panel assembly (1) as in any of the preceding Claims, **characterized in that** the support plate (8) comprises longitudinal protrusions (13) to support and exert tension on the flexible circuit board (7).

9. A control panel assembly (1) as in Claims 1 or 8, **characterized in that** the support plate (8) comprises edge protrusions (17) extending longitudinally along edges of the support plate (8).

10. A method for mounting the support plate (8) of a control panel assembly according to claim 1, said method comprising the following steps:
- attaching one of the sides of the support plate (8) to the control panel frame (6), wherein when the connection units comprise a continuous connection unit (11) the side with the continuous connection unit (11) is attached at first, and
- applying a force on the support plate (8) such that the support plate (8) is bent and the second side opposite to the previously attached side is mounted.

## Patentansprüche

1. Eine Steuertafelanordnung (1) für ein Haushaltsgerät bestehend aus:
- einem äußeren Steuertafel (2) mit einer konvex Form beinhaltend ein Tasteingabegerät (3),
- einem Ausgabe-/Anzeigegerät (4),
- einem Steuertafelrahmen (6) einschließend die äußere Steuertafel (2) und,
- einer flexiblen elektrischen Schaltplatte (7) eingebaut im Innen des Steuertafelrahmens (6),
- einer Stützplatte (8) montiert hinter der flexiblen elektronischen Schaltplatte (7), um dieselbe auf dem Inneren des Steuertafelrahmens (6) zu sichern,
wo
- die Stützplatte (8) eine feste Struktur hat, bedeckt die flexible Schaltplatte (7), und versorgt Zugspannung für die flexible Schaltplatte (7), sodaß sie die konvexe Gestalt der Steuertafel (2) bekommt,
- die Stützplatte (8) beinhaltet Verbindungseinheiten (9), sodaß mindestens zwei separate Verbindungseinheiten (9) getrennte Teile von mechanischer Verbindung mit dem Steuertafelrahmen (6) haben an zwei gegenüberstehenden Seiten der besagten Stützplatte (8),
- die Verbindungseinheiten (9) beinhalten:
(a) mindestens zwei diskontinuierliche Verbindungseinheiten (10) mit getrennten Teile der mechanischen Verbindung mit dem Steuertafelrahmen (6) an einer Seite der Stützplatte (8), oder
(b) eine kontinuierliche Verbindungseinheit (11), die die mechanische Verbindung mit dem Steuertafelrahmen (6) beeinflusst an einer Seite der Stützplatte (8),
- die unterbrochene oder kontinuierliche Verbindungseinheiten (10, 11) einstellt mit einem Steuertafelslot (16) des Steuertafelrahmens (6).

2. Eine Steuertafelanordnung (1) nach Anspruch 1, **dadurch gekennzeichnet, daß** Einstellungsverlängerungen (15) des Steuertafelrahmens (6) mechanisch kooperiert mit mehrfachen Verbindungseinheiten (9) an gegenüberstehender Seite der besagten unterbrochenen oder kontinuierlichen Verbindungseinheiten (10, 11).

3. Eine Steuertafelanordnung (1) nach den vorhergehenden Ansprüche, **dadurch gekennzeichnet, daß** die Stützplatte (8) beinhaltet Beugungskerben (12).

4. Eine Steuertafelanordnung (1) nach Anspruch 3, **dadurch gekennzeichnet, daß** mehrfache Beugungskerben (12) befindlich sind auf der selben Achse.

5. Eine Steuertafelanordnung (1) nach Anspruch 3, **dadurch gekennzeichnet, daß** mehrfache Beugungskerben (12) befindlich sind auf parallelen Achsen.

6. Eine Steuertafelanordnung (1) nach Anspruch 4, **dadurch gekennzeichnet, daß** Beugungskerben (12) befindlich sind auf derselben Achse parallel zu einer Linie, wo entlang der Linie Verbindungseinheiten (9) angeordnet sind.

7. Eine Steuertafelanordnung (1) nach Anspruch 3, **dadurch gekennzeichnet, daß** die Länge einer Beugungskerbe (12), die sich ausstreckt entlang einer longitudinal Achse der Stützplatte (8) größer ist als ihre Breite.

8. Eine Steuertafelanordnung (1) nach den vorhergehenden Ansprüche, **dadurch gekennzeichnet, daß** die Stützplatte (8) beinhaltet longitudinale Vorsprünge (13), um flexible Schaltplatte (7) zu stützen und auf sie Zugspannung auszuüben.

9. Eine Steuertafelanordnung (1) nach Ansprüche 1 oder 8, **dadurch gekennzeichnet, daß** die Stützplatte (8) beinhaltet seitliche Vorsprünge (17), die sich longitudinal entlang der Seiten der Stützplatte (8) ausstrecken.

10. Eine Methode für Montierung der Stützplatte (8) einer Steuertafelanordnung nach Anspruch 1, besagte Methode beinhaltet folgende Schritte:
- Zufügung einer der Seiten der Stützplatte (8) um Steuertafelrahmen (6), wo wenn die Verbindungseinheiten beinhalten eine kontinuierliche Verbindungseinheit (11), die Seite mit kontinuierlicher Verbindungseinheit (11) zuerst zugefügt ist, und
- Ausübung einer Kraft auf die Stützplatte (8), sodaß die Stützplatte (8) sich biegt und die zweite Seite, die der vorher zugefügten Seite gegenübersteht, montiert wird.

## Revendications

1. Ensemble panneau de commande (1) pour un appareil électroménager comprenant:
- un panneau de commande extérieur (2) avec une forme convexe comprenant un dispositif d'entrée tactile (3),
- un dispositif de sortie / affichage (4),
- un cadre de panneau de commande (6) renfermant le panneau de commande extérieur (2) et,
- une carte de circuit électronique flexible (7) fixée à l'intérieur du cadre de panneau de commande (6),
- une plaque de support (8) montée derrière la carte de circuit électronique flexible (7) pour la fixer à l'intérieur du cadre de panneau de commande (6),
dans lequel
- la plaque de support (8) a une structure rigide, recouvre la carte de circuit flexible (7), et fournit une tension à la carte de circuit flexible (7) de sorte qu'elle prend la forme convexe du panneau de commande (2),
- la plaque de support (8) comprend des unités de connexion (9) de sorte qu'au moins deux unités de connexion séparées (9) ont des parties séparées de connexion mécanique avec le cadre de panneau de commande (6) sur deux côtés opposés de ladite plaque de support (8),
- les unités de connexion (9) comprennent:
(a) au moins deux unités de connexion discontinues (10) ayant des parties séparées de connexion mécanique avec le cadre de panneau de commande (6) d'un côté de la plaque de support (8), ou
(b) une unité de connexion continue (11) effectuant une connexion mécanique avec le cadre de panneau de commande (6) d'un côté de la plaque de support (8),
- les unités de connexion discontinues ou continues (10, 11) sont en prise avec une fente de panneau de commande (16) du cadre de panneau de commande (6).

2. Ensemble panneau de commande (1) selon la revendication 1, **caractérisé en ce que** des prolongements d'engagement (15) du cadre de panneau de commande (6) coopèrent mécaniquement avec plusieurs unités de connexion (9) du côté opposé desdites unités de connexion discontinues ou continues (10, 11).

3. Ensemble panneau de commande (1) selon l'une quelconque des revendications précédentes, **caractérisé en ce que** la plaque de support (8) comprend des fentes de flexion (12).

4. Ensemble panneau de commande (1) selon la revendication 3, **caractérisé en ce que** plusieurs fentes de flexion (12) sont situées sur le même axe.

5. Ensemble panneau de commande (1) selon la revendication 3, **caractérisé en ce que** plusieurs fentes de flexion (12) sont situées sur des axes parallèles.

6. Ensemble panneau de commande (1) selon la revendication 4, **caractérisé en ce que** les fentes de flexion (12) sont situées sur le même axe parallèle à une ligne le long de laquelle sont disposées des unités de connexion (9).

7. Ensemble panneau de commande (1) selon la revendication 3, **caractérisé en ce que** la longueur d'une fente de flexion (12) s'étendant le long d'un axe longitudinal de la plaque de support (8) est plus longue que sa largeur.

8. Ensemble panneau de commande (1) selon l'une quelconque des revendications précédentes, **caractérisé en ce que** la plaque de support (8) comprend des protubérances longitudinales (13) pour supporter et exercer une tension sur la carte de circuit flexible (7).

9. Ensemble panneau de commande (1) selon les revendications 1 ou 8, **caractérisé en ce que** la plaque de support (8) comprend des protubérances de bord (17) s'étendant longitudinalement le long des bords de la plaque de support (8).

10. Procédé de montage de la plaque de support (8) d'un ensemble panneau de commande selon la revendication 1, ledit procédé comprenant les étapes suivantes:
- attacher l'un des côtés de la plaque de support (8) au cadre de panneau de commande (6), dans lequel les unités de connexion comprennent une unité de connexion continue (11), le côté avec l'unité de connexion continue (11) étant fixé en premier;
- appliquer une force sur la plaque de support (8) de telle sorte que la plaque de support (8) soit courbée et que le second côté opposé au côté précédemment fixé soit monté.
